Europäisches Patentamt

European Patent Office

Office européen des brevets

(19)

(11) **EP 0 447 764 B1**

(12) **EUROPÄISCHE PATENTSCHRIFT**

(45) Veröffentlichungstag und Bekanntmachung des Hinweises auf die Patenterteilung:
**08.05.1996 Patentblatt 1996/19**

(51) Int Cl.6: **H01J 37/34**, C23C 14/35, C23C 14/50

(21) Anmeldenummer: **91101178.1**

(22) Anmeldetag: **30.01.1991**

(54) **Vorrichtung zum Beschichten von Substraten durch Kathodenzerstäubung**

Cathodic sputtering substrate coating device

Dispositif pour le revêtement de substrats par pulvérisation cathodique

(84) Benannte Vertragsstaaten:
**AT CH DE FR GB IT LI NL SE**

(30) Priorität: **22.03.1990 DE 4009151**

(43) Veröffentlichungstag der Anmeldung:
**25.09.1991 Patentblatt 1991/39**

(73) Patentinhaber: **LEYBOLD AKTIENGESELLSCHAFT**
**D-63450 Hanau (DE)**

(72) Erfinder:
• **Hensel, Bernd, Dipl.-Ing.**
 **W-6230 Frankfurt am Main 80 (DE)**

• **Hofmann, Dieter, Dipl.-Ing.**
 **W-6454 Bruchköbel (DE)**
• **Eckhardt, Gunter, Dipl.-Ing.**
 **W-6450 Hanau am Main 1 (DE)**
• **Kopacz, Uwe, Dr.-Phys.**
 **W-6452 Hainburg 1 (DE)**
• **Schüssler, Hans, Dipl.-Ing.**
 **W-6685 Schiffweiler (DE)**

(74) Vertreter: **Zapfe, Hans, Dipl.-Ing.**
**Postfach 20 01 51**
**D-63136 Heusenstamm (DE)**

(56) Entgegenhaltungen:
EP-A- 0 209 469      WO-A-86/04616
US-A- 4 407 713      US-A- 4 478 703

**Beschreibung**

Die Erfindung betrifft eine Vorrichtung zum Beschichten von Substraten durch Katodenzerstäubung mit

a) einer rechteckigen Magnetronkatode, die ein Target mit Längskanten aufweist und einen Beschichtungsbereich definiert,

b) einem um eine zu den Längskanten parallele Drehachse drehbaren Substrathalter für Substrate, deren Oberflächenelemente auf Kreisbahnen durch den Beschichtungsbereich bewegbar sind,

c) einer flächenhaften, aus amagnetischem Werkstoff bestehenden Wand mit Längskanten, die gleichfalls parallel zur Drehachse des Substrathalters verlaufen, wobei hinter der Wand eine Magnetanordnung zur Erzeugung mindestens eines langgestreckten magnetischen Tunnels angeordnet ist, der sich über die dem Substrathalter zugekehrte Oberfläche der Wand erstreckt, wobei sich die Magnetronkatode und die Wand auf gegenüberliegenden Seiten der Drehachse befinden und die Langseiten des magnetischen Tunnels gleichfalls parallel zu den Längskanten des Targets verlaufen, sowie mit

d) einer flächenhaften Anode.

Bei den Substraten handelt es sich insbesondere, aber nicht ausschließlich, um solche mit großen Abmessungen und/oder mit einer komplizierten dreidimensionalen Form. Es ist mit den herkömmlichen Vorrichtungen, die mindestens eine Magnetronkatode besitzen, schwierig, derartige Substrate allseitig und gleichmäßig zu beschichten, und es ist auch schwierig, alle Oberflächenelemente derartiger Substrate vor der Beschichtung gleichmäßig zu ätzen bzw. zu reinigen, ein Vorgang, der einen gleichmäßigen Ionenbeschuß über die gesamte Oberfläche voraussetzt.

Beim Einsatz von Magnetronkatoden stehen sich nämlich zwei Forderungen diametral entgegen: Zum einen ist die Magnetron-Zerstäubungskatode durch eine ganz spezielle Zuordnung eines Magnetsystems zum Target, das aus dem Beschichtungsmaterial oder wenigstens einer Komponente des Beschichtungsmaterials besteht, eine sogenannte Hochleistungs-Beschichtungsquelle, d.h. eine Beschichtungsquelle mit hoher Zerstäubungsrate pro Oberflächeneinheit, zum andern wird durch das Magnetfeld das Plasma bzw. die Glimmentladung sehr weitgehend von den Substraten ferngehalten, sofern man nicht bestimmte Maßnahmen ergreift, die aber auch teilweise sehr komplexer Natur sind, worauf weiter unten noch näher eingegangen wird. Man nennt das Zusammenwirken von Magnetfeld und Target auch eine "magnetische Falle".

Die Eigenschaft einer Hochleistungszerstäubung wird ja gerade durch die starke Konzentration des Plasmas auf der Substratoberfläche erreicht, und genau dies ist die Ursache für die geringe Raumausdehnung des Plasmas, die der Forderung entgegensteht, die Substrate im Plasma "zu baden".

Magnetron-Zerstäubungskatoden sind hinreichend bekannt; es wird hier beispielhaft auf die DE-PS 24 63 431 verwiesen, die ein sogenanntes "planares Magnetron" offenbart.

Eine solche Magnetronkatode ist ohne weitere Maßnahmen nicht für das allseitige Beschichten dreidimensionaler Substrate geeignet, und zwar auch dann nicht, wenn man das Substrat durch mehrachsige Raumbewegungen eines Substrathalters komplexe, zusammengesetzte Bewegungen ausführen läßt.

Durch die DE-PS 31 07 914 ist es bereits bekannt, dreidimensionale Substrate allseitig dadurch zu beschichten, daß man die Substrate ohne Rotationsbewegung durch den Zwischenraum von zwei spiegelbildlich gegenüberliegenden Magnetronkatoden hindurchführt und die Geometrie der gesamten Anordnung, die Auslegungsdaten der Magnetronkatoden und die Betriebsparameter einschließlich einer negativen Bias-Spannung an den Substraten so wählt, daß die Substrate allseitig dem Plasma ausgesetzt sind. Diese Maßnahme hat sich bis zu einer gewissen Substratgröße hervorragend bewährt, die durch einen Abstand der Targetoberflächen von etwa 120 mm vorgegeben ist. Dabei ist zu berücksichtigen, daß selbst vorspringende Teile der Substrate einen gewissen Mindestabstand von den Targetoberflächen nicht unterschreiten dürfen, so daß die größte Abmessung der Substrate in Normalenrichtung der Targetoberflächen auf maximal etwa 30 bis 40 mm begrenzt ist.

In der internationalen Patentanmeldung WO 86/04 616 ist eine Vorrichtung nach dem Oberbegriff des Anspruchs 1 beschrieben, und zwar sind für einen ganz bestimmten Zweck (Beschichtung mit sogenannten Hartstoffen) Maßnahmen und Mittel angegeben, mit denen dreidimensionale Substrate unterschiedlicher Größe allseitig mit einer haftfesten Schicht aus Hartstoffen überzogen werden können. Dies geschieht einerseits durch eine Substratrotation, andererseits durch den Einschuß zusätzlicher Elektronen in den Beschichtungsbereich der Magnetron-Katode. Für diesen Zweck ist eine zusätzliche Anordnung von Elektronen-Emittern und Gegenelektroden vorgesehen, die einen zusätzlichen Elektronenstrom erzeugen. Bei dieser Anordnung sind die Substrate einer zusätzlichen Temperaturbelastung durch die Strahlung der Emitter ausgesetzt. Dadurch werden Temperaturen von 200 °C, die für bestimmte Werkstoffe wie z.B. Stähle schädlich sind, bereits nach kurzer Dauer überschritten. Das Plasma ist auch bei diesem Stand der Technik räumlich eng begrenzt. Die Substrate durchlaufen also periodisch das Plasma und plasmafreie Zonen, wobei der größte Teilumfang der Substratbahnen außerhalb der Plasmazone liegt. Auch bei dieser bekannten Vorrichtung ist die maximale Größe der Substrate relativ eng begrenzt.

Es ist auch bereits bekannt, die räumliche Ausdehnung des Plasmas bei einer Magnetronkatode dadurch zu vergrößern, daß man die Magnetronkatode in einem Betriebszustand betreibt, der bezüglich des Magnetsystems als nicht im Gleichgewichtszustand befindlich bezeichnet werden kann. Durch unterschiedlich große Polflächen der Magnetsysteme und/oder durch zusätzliche Magnetspulen wird hierbei erreicht, daß ein beträchtlicher Teil der magnetischen Feldlinien nicht mehr auf relativ kurzen bogenförmigen Bahnen zur Targetoberfläche zurückkehrt, sondern sich weit in den Raum hinaus bis zur Gegenelektrode erstreckt, die in der Regel als Substrathalter ausgebildet ist und die Substrate trägt. Man bezeichnet solche Magnetronkatoden infolge dieser Wirkungsweise auch als "Unbalanced Magnetrons". Derartige Systeme sind beispielhaft von den Autoren B. Window und N. Savvides beschrieben:

1. "Charged particle fluxes from planar magnetron sputtering sources",
J. Vac. Sci. Technol. A 4 (2), März/April 1986, Seiten 196 bis 202 und

2. "Unbalanced" dc magnetrons and sources of high ion fluxes",
J. Vac. Sci. Technol. A 4 (3), Mai/Juni 1986, Seiten 453 bis 456.

Mit diesen Systemen gelingt es zwar, hohe mittlere Substratstromdichten zu erzeugen, nicht aber eine genügend gleichmäßige Einwirkung des Plasmas auf die Substrate, insbesondere nicht beim Ätzen bzw. Reinigen.

Eine wichtige Bedingung für den erfolgreichen Einsatz einer Hartstoff-Schicht ist außer eine großen Dichte der Schicht eine ausreichende Haftung zwischen dem Substrat und der Beschichtung. Zu diesem Zweck ist es erforderlich, beim Ätz- oder Reinigungsprozeß auf der gesamten Oberfläche des Formteils ein Abtragen des Substratmaterials zu erzeugen. Bei einem geometrisch komplizierten großen Formteil ist es kritisch, die gleichmäßige Abtragung allein unter Verwendung einer hohen negativen Spannung am Substrat erreichen zu wollen. Werden nämlich am Substrat bei Drücken von einigen $10^{-2}$ mbar (Argon) hohe negative Substratpotentiale angelegt, so ist es nur möglich, sehr geringe Stromdichten unterhalb von 0,2 mA/cm$^2$ Substratoberfläche für den Ionenbeschuß am Substrat beim Ätzvorgang anzuwenden.

Die daraus resultierenden geringen Abtragsraten führen dazu, daß einerseits an der Oberfläche positionierte Flächenelemente, die leicht zugänglich sind, stärker abgetragen werden, und, daß andererseits an Kanten eine Überätzung stattfindet. An verborgenen Innenflächen des Formteils findet aber nur eine sehr geringe oder überhaupt keine Abtragung statt, so daß an diesen Stellen eine schlechte Haftfestigkeit bereits vorgegeben ist.

Es wurde außerdem bereits beobachtet, daß durch die für den Ätzvorgang erforderlichen relativ hohen Prozeßdrücke eine Rückstreuung (Redeposition) von abgetragenem Material aus dem Bereich der exponierten Oberflächenteile auf die Oberflächenteile mit schwacher oder gar keiner Ätzung stattfindet. Hierdurch wird auf großen Teilen der Substratoberfläche kein Ätzprozeß ermöglicht.

Der Erfindung liegt daher die Aufgabe zugrunde, eine Vorrichtung der eingangs beschriebenen Gattung dahingehend zu verbessern, daß mit dieser auch Substrate großer Querabmessungen und unregelmäßiger Form mit großer Gleichförmigkeit wahlweise sowohl geätzt (gereinigt) als auch mit großer Haftfestigkeit der aufgebrachten Schichten beschichtet werden können. Unter "Querabmessungen" der Substrate werden die maximalen Abstände zweier Punkte innerhalb der einzelnen Querschnittsebenen verstanden, die senkrecht zur Targetoberfläche und zur Drehachse des Substrathalters verlaufen, also den minimal möglichen Abstand der Drehachse des Substrathalters von der Targetoberfläche bestimmen.

Die Lösung der gestellten Aufgabe erfolgt bei der eingangs angegebenen Vorrichtung erfindungsgemäß dadurch, daß

e) der Abstand zwischen den Längskanten des Targets und den hierzu parallelen Längskanten der Wand auf dem Umfang der Substratbahnen durch mindestens eine weitere Wand mit einer dahinter angeordneten Magnetanordnung verkürzt ist, wobei die mindestens eine weitere Magnetanordnung unter einem Winkel zur ersten Magnetanordnung ausgerichtet ist, und daß

f) die Pole aller Magnetanordnungen sich auf dem Umfang des Substrathalters abwechseln, derart, daß der gesamte Umfang des Substrathalters von einer ununterbrochen Folge von magnetischen Tunnels umgeben ist.

Die Bedeutung der konstruktiven Vorschriften nach den Merkmalen e) und f) wird weiter unten anhand einer vergleichenden Gegenüberstellung zwischen dem Stande der Technik noch näher erläutert werden. Wesentlich ist hierbei zunächst einmal, daß die Substratbahnen auf ihrem gesamten Umlaufwege innerhalb des Plasmas verlaufen, was dadurch bewirkt wird, daß die Substratbahnen von einer ununterbrochen Folge von magnetischen Tunnels umgeben sind.

Bei Anwendung der erfindungsgemäßen Lösung lassen sich bei einem Druck von 1,8 x $10^{-2}$ mbar (Argon), einem Substratpotential von -1750 Volt und einem Anodenpotential von +40 Volt beim Ätzen Stromdichten von deutlich über 1 mA/cm$^2$ Substratfläche am Substrat erzeugen. Dadurch wurden sämtliche Oberflächenelemente der Substrate dem Ätzprozeß unterworfen, und zwar auch solche Oberflächenteile, die sich auf Innenflächen befinden, beispielsweise auf den Innenflächen von Lagerringen.

Beim Beschichten dieser Substrate wurden bei einem Druck von $6 \times 10^{-3}$ mbar (Argon), einem Katodenpotential von -550 Volt und einem Substratpotential von -60 Volt Stromdichtewerte erreicht, die in Abhängigkeit von der Magnetfeldstärke am Target zwischen 1,0 und 1,5 mA/cm² Substratfläche betrugen. Die erhaltenen Schichten zeichneten sich durch gute Haftung am Substrat, einen niedrigen Reibungskoeffizienten und einen geringen Verschleißabtrag bei den weiter unten noch näher beschriebenen Untersuchungsmethoden aus.

Es ist dabei von Vorteil, wenn die Wände der Magnetanordnungen in einer polygonalen Hüllfläche liegen, die mindestens den außerhalb der Sichtverbindung mit der Magnetronkatode liegenden Teilumfang der Substratbahnen umschließt.

Weitere vorteilhafte Ausgestaltungen des Erfindungsgegenstandes ergeben sich aus den übrigen Unteransprüchen.

Zwei Ausführungsbeispiele des Erfindungsgegenstandes werden nachfolgend unter Gegenüberstellung mit dem Stande der Technik anhand der Figuren 1 bis 7 näher erläutert.

Es zeigen:

Figur 1    eine Anordnung von Substrathalter und Magnetronkatode nach dem Stande der Technik,

Figur 2    eine Anordnung nach der Erfindung mit mehreren Magnetanordnungen und einer gekrümmten flächenhaften Anode,

Figur 3    eine typische Anordnung von Substraten (Lagerringen) auf einem drehbaren Substrathalter,

Figur 4    ein Diagramm über die Abhängigkeit der Mikrohärte $HV_{0,01}$ von dem der Vorrichtung zugeführten Stickstoff-Fluß,

Figur 5    ein Diagramm über die Abhängigkeit der Substratstromdichte $A_S$ vom Anodenpotential $V_A$,

Figur 6    ein Diagramm über die Abhängigkeit der Substratstromdichte $A_S$ vom Substratpotential in Vergleichsdarstellung für Vorrichtungen mit und ohne erfindungsgemäße Einrichtungen, und

Figur 7    eine erfindungsgemäße Vorrichtung analog Figur 2, jedoch mit einem deutlich größeren Substrat bzw. Substrathalter.

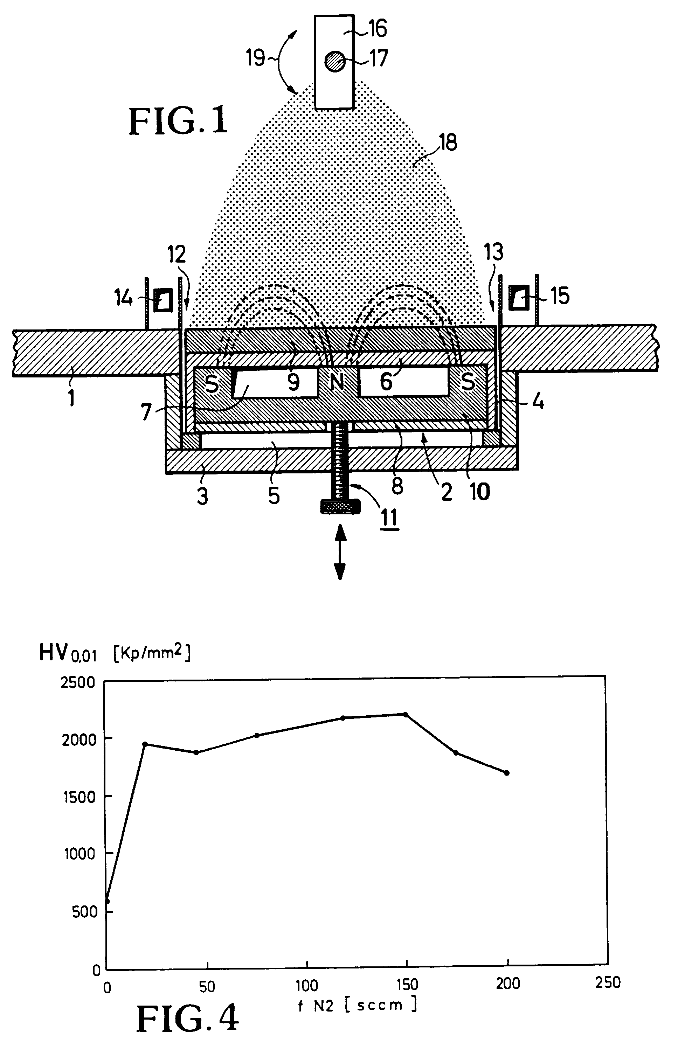

In Figur 1 ist eine einseitig wirkende Vorrichtung nach dem Stande der Technik dargestellt. In einer Wand einer Vakuumkammer 1 ist eine Magnetronkatode 2 herkömmlicher Bauart eingesetzt. Zu diesem Zweck ist die Vakuumkammer 1 mit einem quaderförmigen, hohlen Gehäuseansatz 3 versehen, der die Magnetronkatode 2 mit so geringen Abständen umschließt, daß sich in den dadurch gebildeten Spalten 4 und 5 keine Glimmentladungen ausbilden können.

Bei der Magnetronkatode 2 handelt es sich um eine sogenannte Rechteck-Katode, deren Hauptausdehnungsrichtung (längste Achse) senkrecht zur Zeichenebene verläuft. Zur Magnetronkatode 2 gehört ein wannenförmiger Grundkörper 6 mit einem Hohlraum 7, der durch einen Deckel 8 verschlossen ist. Auf der Vorderseite des Grundkörpers 6 befindet sich in gut wärmeleitender Verbindung ein plattenförmiges Target 9, das aus dem Beschichtungsmaterial oder wenigstens einer Komponente des Beschichtungsmaterials besteht.

Im Hohlraum 7 befindet sich ein Magnetsystem 10, das einen geschlossenen Tunnel aus Magnetfeldlinien bildet, der in der Projektion auf das Target 9 die Form einer "Rennbahn" hat. Zum Magnetsystem 10 gehört eine mittlere Reihe von Permanentmagneten in linearer Anordnung, die in Richtung der längsten Achse der Magnetronkatode verläuft. Diese Reihe ist mit dem Nordpol "N" dem Target 9 zugekehrt. In unmittelbarer Nähe der Zarge des Grundkörpers 6 befindet sich eine auf dem Umfang geschlossene ununterbrochene Folge von weiteren Permanentmagneten mit entgegengesetzter Pollage, d.h. in diesem Falle ist der Südpol "S" dem Target 9 zugekehrt.

Wie aus Figur 1 ersichtlich ist, umgibt die äußere Folge von Permanentmagneten in Form eines Rechtecks die innere, leistenförmige Reihe von Permanentmagneten mit einem Abstand. Die gegenüberliegenden Seiten der Permanentmagnete sind durch eine nicht näher bezeichnete Jochplatte miteinander verbunden. Weitere Ausführungen zur Konstruktion der Magnetronkatode 2 dürften entbehrlich sein, da derartige Katoden Stand der Technik sind. Stand der Technik ist auch eine Verstelleinrichtung 11 für das Magnetsystem 10, die aus einer Gewindespindel besteht, mit den der Abstand zwischen den Polflächen der Permanentmagnete und der Vorderseite des Grundkörpers 6 veränderbar ist. Durch die Verstelleinrichtung können Einflüsse des zunehmenden Verbrauchs des Targetmaterials ausgeglichen werden.

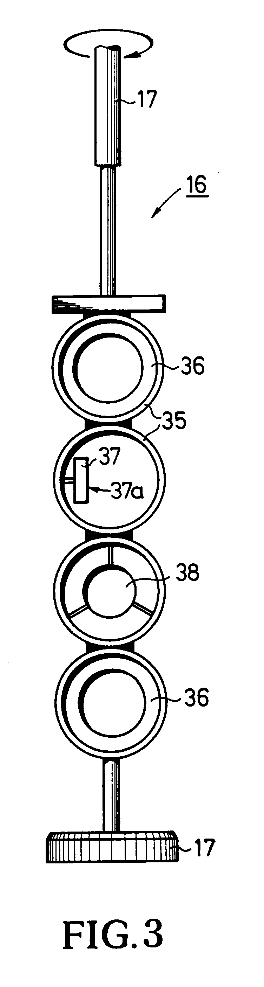

Das Target 9 besitzt zwei geradlinige Längskanten 12 und 13, die gleichfalls senkrecht zur Zeichenebene verlaufen. Parallel zu diesen Längskanten erstrecken sich zwei Gasverteilersysteme 14 und 15, mit dem dem Zerstäubungsprozeß reaktive Gase wie beispielsweise Stickstoff zugeführt werden können, wenn beispielsweise aus einem Target 9 aus Chrom Chromnitrid auf den Substraten niedergeschlagen werden soll. Ein Substrathalter 16 ist in Figur 1 als Rechteck dargestellt. Er besitzt eine Drehachse 17, die senkrecht zur Zeichenebene und damit parallel zu den Längskanten 12 und 13 und gleichfalls parallel zu den Gasverteilersystemen 14 und 15 verläuft. Auf dieser Drehachse können beispielsweise Lagerringe angeordnet sein, wie dies in Figur 3 dargestellt ist.

Durch eine entsprechende Auslegung des Magnetsystems 10 in Verbindung mit einer entsprechenden Wahl der Betriebsparameter einschließlich einer ausreichenden negativen Bias-Spannung am Substrathalter 16 läßt sich erreichen, daß sich das Plasma - wie in Figur 1 kreuzschraffiert dargestellt - bis zum Substrathalter 16 ausdehnt. Es gelingt aber auf diese Weise beispielsweise nicht, das Plasma 18 auch auf die dem Target 9 abgekehrte Rückseite des Substrathalters 16 auszudehnen. Eine allseitige Beaufschlagung des Substrathalters 16 bzw. der Substrate ist nur möglich, wenn der Substrathalter 16 kontinuierlich in Richtung des Pfeils 19 gedreht wird. Dadurch werden aber dem Target 9 abgekehrte Oberflächenelemente der Substrate auf einem Teilumfang der Substratbahnen, d.h. zeitweise, dem Einfluß des Plasmas entzogen.

Bei einer solchen Vorrichtung liegt der mittlere Substratstrom selbst bei Optimierung aller anderen Verfahrensparameter unterhalb von 0,5 mA/cm$^2$. Die Folgen wurden in der Beschreibungseinleitung angegeben. Es versteht sich, daß die Drehachse 17 in der längsten Symmetrieebene der Magnetronkatode 2 liegt und einen durch Versuche zu optimierenden Abstand von der Targetoberfläche hatte.

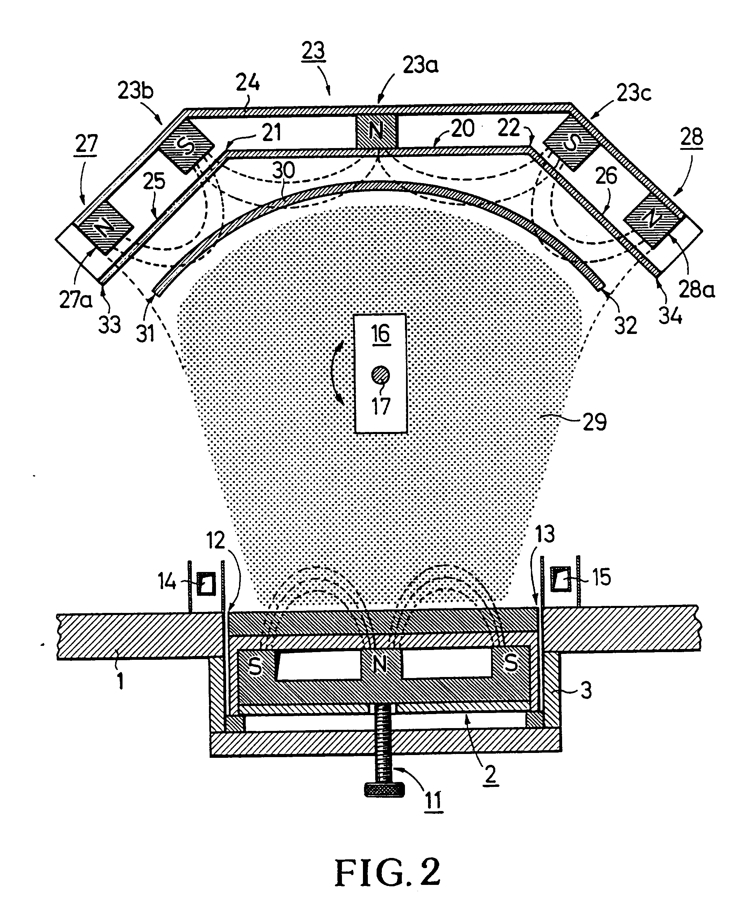

Die Magnetronkatode 2 nach Figur 2 ist einschließlich ihrer Unterbringung in dem Gehäuseansatz 3 mit derjenigen nach Figur 1 identisch.

In Abweichung zum Gegenstand von Figur 1 ist die Anordnung nach Figur 2 jedoch zusätzlich mit einer ebenen, aus amagnetischem Werkstoff bestehenden Wand 20 versehen, die auf der dem Target 9 abgekehrten Seite des Substrathalters 16 angeordnet ist. Diese Wand besitzt Längskanten 21 und 22, die gleichfalls parallel zur Drehachse 17 des Substrathalters 16 verlaufen. Hinter dieser Wand ist eine weitere Magnetanordnung 23 angeordnet, die aus einer mittleren Leiste von Permanentmagneten 23a und zwei flankierenden äußeren Leisten von Permanentmagneten 23b und 23c besteht. Die äußeren Permanentmagnete 23b und 23c haben eine entgegengesetzte Pollage zu den mittleren Permanentmagneten 23a. Auf diese Weise verlaufen die Magnetfeldlinien auf bogenförmigen Bahnen von der mittleren Reihe von Permanentmagneten 23a zu den beiden äußeren Reihen von Permanentmagneten 23b und 23c, wie dies punktiert angedeutet ist. Auf der der Wand 20 abgekehrten Seite sind die Permanentmagnete 23a, 23b und 23c durch eine Jochplatte 24 magnetisch miteinander verbunden. Es spielt dabei keine entscheidende Rolle, daß die beiden äußeren Reihen von Permanentmagneten 23b, 23c etwas außerhalb der Längskanten 21 und 22 liegen, da die ebene Wand 20 beiderseits der Längskanten 21 und 22 durch weitere Wände 25 und 26 aus amagnetischem Material fortgesetzt wird, die mit der Wand 20 gegenüber dem Target 9 einen stumpfen Winkel von beispielsweise 135 Grad einschließen. Bis zu den Längskanten 21 und 22 ist die Vorrichtung nach Figur 2 einschließlich der Reihenanordnungen von Permanentmagneten 23a, 23b und 23c Stand der Technik (WO 86/04616, aber ohne Emitter).

Im Unterschied zu diesem Stand der Technik sind jedoch unmittelbar angeschlossen die beiden weiteren Wände 25 und 26 vorgesehen, hinter denen sich auf jeder Seite eine weitere Magnetanordnung 27 und 28 befindet, zu der jeweils eine geradlinige Reihe von Permanentmagneten 27a bzw. 28a gehört. Hierbei versteht es sich, daß wirkungsmäßig zu der Magnetanordnung 27 noch die Reihe von Permanentmagneten 23b gehört und zu der Magnetanordnung 28 noch die Reihenordnung von Permanentmagneten 23c. Weiterhin ist die Pollage der Permanentmagnete 27a und 28a zu derjenigen der Permanentmagnete 23b und 23c entgegengesetzt, so daß sich auch zwischen diesen Polen bogenförmig verlaufende Magnetfeldlinien ausbilden.

Es ist ersichtlich, daß durch die Wände 25 und 26 und die weiteren Magnetanordnungen 27 und 28 - in Umfangsrichtung zur Drehachse 17 gesehen - der Abstand zu den Längskanten 12 und 13 des Targets 9 deutlich verkürzt ist. Weiterhin wurde bezüglich der Pollage des Magnetsystems 10 und der Pollage der Permanentmagnete 27a und 28a so verfahren, daß auch hier die auf dem kürzesten Wege zu erreichenden Pole eine entgegengesetzte Pollage aufweisen. So sind bei dem gezeigten Ausführungsbeispiel die freien Polflächen der Permanentmagnete 27a und 28a als Nordpole ausgebildet, und die freien Polflächen der außenliegenden Permanentmagnete des Magnetsystems 10 sind als Südpole ausgebildet. Infolgedessen verlaufen auch Magnetfeldlinien von den Polflächen der Permanentmagnete 27a und 28a zu den jeweils am nächsten liegenden Polflächen des Magnetsystems 10 der Magnetronkatode 2.

Dadurch ergibt sich eine solche Konstellation, daß sich auf dem Umfang der Drehachse 17 des Substrathalters 16 die Pole aller Magnetanordnungen 23, 27 und 28 einschließlich der Pole des Magnetsystems 10 der Magnetronkatode 2 abwechseln. Der dadurch erzwungene Verlauf der Magnetfeldlinien führt dazu, daß sich das Plasma 29 über ein deutlich größeres Volumen erstreckt und insbesondere den Substrathalter 16 allseitig umspült, was zu den weiter oben beschriebenen Vorteilen führt.

Die Wände 20, 25 und 26 liegen auf den kürzeren Seiten eines Trapezes und umschließen damit einen trapezförmigen Hohlraum, der in Richtung auf die Magnetronkatode 2 geöffnet ist. In diesem Hohlraum befindet sich noch eine Anode 30, die einen Sektor eines dünnwandigen Hohlzylinders bildet, wobei deren Längskanten 31 und 32 in der Nähe der äußersten Längskanten 33 und 34 der Wände 25 und 26 liegen. Auch diese Anode dient naturgemäß zur Formung des Plasmas 29. Notwendigerweise hat dieses Plasma 29 einen Abstand von der Anode 30, da diese eine Senke für die den Prozeß unterhaltenden Elektronen darstellt, so daß die Ionisationswahrscheinlichkeit in unmittelbarer Nähe der Anode 30 deutlich verringert ist. Es entsteht also auch hier der bekannte Dunkelraum.

Von Bedeutung ist, daß sich sämtliche denkbaren Oberflächenelemente des Substrathalters 16 bzw. der Substrate auf Substratbahnen bewegen, die innerhalb des Plasmas 29 liegen, womit sich diese Vorrichtung deutlich von derjenigen nach Figur 1 unterscheidet.

Es ist noch zu betonen, daß die Magnetronkatode 2, die Gasverteilersysteme 14 und 15, die Wände 20, 25 und 26, die Reihen von Permanentmagneten und die Anode 30 - sämtlich senkrecht zur Zeichenebene gesehen - im wesentlichen die gleiche Länge haben wie der Substrathalter 16 bzw. dessen Drehachse 17, die im allgemeinen senkrecht ausgerichtet ist, so daß die besagten Substratbahnen in waagrechten Ebenen verlaufen.

Zu den - in der Zeichenebene nach Figur 2 liegenden - Querabmessungen der Wände 20, 25 und 26 und der Anode 30 ist noch folgendes auszuführen: Der Abstand der Längskanten 21 und 22, die durch entsprechendes Biegen eines aus amagnetischem Werkstoff bestehenden Blechs entstanden sind, entspricht mindestens im wesentlichen in etwa der Breite des Targets 9, d.h. dem Abstand von dessen Längskanten 12 und 13. Die Abstände zwischen den Längskanten 21 und 33 einerseits und 22 und 34 andererseits entsprechen mindestens etwa der Hälfte des Abstandes der Längskanten 21 und 22 voneinander. Die Bogenlänge der Anode 30 zwischen den Längskanten 31 und 32 kann dabei durch Optimierungsversuche festgelegt werden. Es wurde nämlich festgestellt, daß bei einer Veränderung dieser Bogenlänge ein optimaler Zustand dann erreicht wird, wenn die Substratstromdichte einen maximal möglichen Wert aufweist.

Zum Zwecke einer Dimensionierung wird in einem Diagramm die Substratstromdichte über der Bogenlänge der Anode aufgetragen. Verändert man die besagte Bogenlänge von einem schmalen Blechstreifen von etwa 2 cm Breite bis zu einem Wert, bei dem die Anode die Drehachse 17 nahezu auf dem halben Umfang umgibt, und trägt man die Werte für die Substratstromdichte in das Diagramm ein, so ergeben sich an beiden Enden der Kurve zwei Maximalwerte. Der eine Maximalwert entspricht einer Konfiguration, die in etwa maßstäblich derjenigen nach Figur 2 entspricht, d.h. die Anode umgibt die Drehachse 17 auf einem Umfang von etwa 120 Grad. In diesem Fall kann die Vorrichtung sehr universell für kleine und große Substrate eingesetzt werden.

Figur 3 zeigt einen Substrathalter 16 mit vier Halteringen 35, die zur Aufnahme von Substraten 36 vorgesehen sind, die als Lagerringe ausgeführt sind und einen Außendurchmesser von 65 mm bei einer axialen Länge von etwa 25 mm besitzen. Die Halteringe 35 sind untereinander verschweißt und in der gezeigten linearen Ausrichtung an der Drehachse 17 befestigt, die Teil des Substrathalters 16 ist. Einzelheiten der Befestigung und der Drehantrieb sind der Einfachheit halber fortgelassen. Die Lagerringe sollen auf ihren Innenflächen geätzt und beschichtet werden.

In dem einen Haltering 35 befindet sich seitlich ein Probesubstrat 37 von 30 mm Durchmesser und 5 mm Dicke, dessen eine Stirnfläche 37a senkrecht zu den Ringebenen verläuft. In einem anderen Haltering 35 befindet sich mittig ein weiteres Probesubstrat 38, dessen beiden Stirnflächen parallel zu den Ringebenen verlaufen. Diese Probesubstrate dienen zur Untersuchung der repräsentativen Produkteigenschaften, weil die Innenflächen der Lagerringe den üblichen Untersuchungsgeräten nicht ohne weiteres zugänglich sind.

**Beispiel 1 (Vergleichsbeispiel):**

Eine Anlage vom Typ Z 700 P2/2 der Anmelderin wurde mit einer Magnetronkatode des Typs PK 500 L bestückt, wobei das Target 9 aus Chrom bestand. Substrathalter und Substrate entsprachen dabei der Anordnung nach Figur 3. Durch die Gasverteilersysteme 14 und 15 konnte wahlweise reines Argon (zum Ätzen) oder ein Gemisch von Argon und Stickstoff (zur Niederschlagung von Schichten aus Chromnitrid) eingelassen werden. Die Anlage wurde zunächst in Übereinstimmung mit Figur 1 ausgerüstet, wobei der Substrathalter und die Wände der Vakuumkammer Anodenfunktion übernahmen.

Die Substrate bestanden aus den Werkstoff 100Cr6 mit einer maximalen Temperaturbelastbarkeit von 200 °C.

Zum Zwecke einer Ätzreinigung wurde durch Einlaß von reinem Argon ein Prozeßdruck von $1,8 \times 10^{-2}$ mbar erzeugt, und es wurden an das Substrat -1750 V angelegt. Die Magnetronkatode 2 wurde bei einem Potential von -280 V bei einem Katodenstrom von 0,7 A betrieben. Dabei wurde ein maximaler Substratstrom von 80 mA erzielt. Der zeitliche Verlauf dieses Stroms zeigte jedoch aufgrund der Drehung der Drehachse 17 starke Änderungen des Substratstroms, wobei eine Verringerung bis zu 50 % zu beobachten war. Diese Stromschwankungen rührten daher, daß die Substrate je nach ihrer Winkelstellung relativ zur Magnetronkatode 2 unterschiedlich stark in das Plasma 18 eingetaucht und wieder aus diesem heraus bewegt wurden. Dadurch wurde augenscheinlich, daß nur in besonders günstig gelegenen Oberflächenbereichen der Substrate eine Ätzwirkung erzeugt wurde.

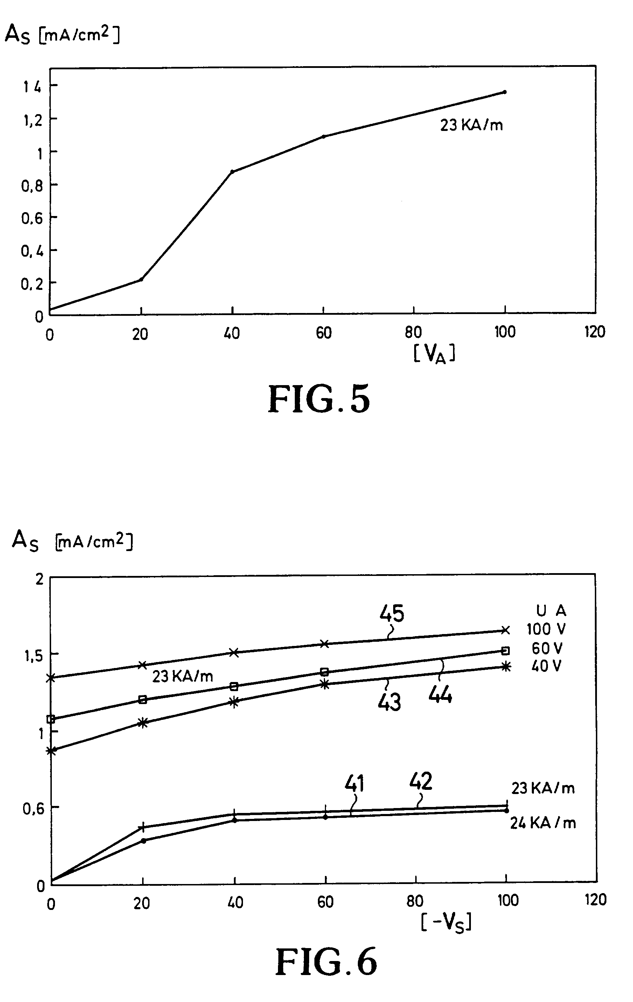

Nach Beendigung der Ätzreinigung wurde eine Änderung der Potentiale von Substrathalter und Magnetronkatode vorgenommen. Zum Zwecke einer Beschichtung wurde die Katode mit einem Potential von -560 V betrieben, wobei sich ein Katodenstrom von 7,2 A ergab. Dem Argonstrom wurden 27 sccm Stickstoff beigemischt. Figur 4 zeigt die Abhängigkeit der Mikrohärte $HV_{0,01}$ in Abhängigkeit von diesem Stickstoff-Fluß. Es ist erkennbar, daß auch eine wesentliche Steigerung des Stickstoff-Flusses die Mikrohärte nicht weiter verbessert, obwohl bei diesem, als niedrig zu bezeichnenden Stickstoff-Fluß eine unterstöchiometri-

sche Beschichtung aus $CrN_x$ vorlag. Die beschriebenen Bedingungen sollten eigentlich erwartungsgemäß dazu führen, daß bei dem noch weitgehend metallischen Charakter des Hartstoffmaterials eine gute Haftung vorliegt.

Die derart beschichteten Probesubstrate wurden anschließend in einem sogenannten "Tribometer" getestet. Die Beschichtung bestand aus einer einzigen Schicht aus 2,0 μm $CrN_x$.

Bei dem Tribometer handelt es sich um eine "Pin-on-Disc-Maschine" des Typs SIN der Firma CSEM in CH-2000 Neuchatel 7/Schweiz. Der Gegenkörper war eine Hartmetallkugel mit einer Auflagelast von 2,5 N. Die Relativgeschwindigkeit betrug von 0,6 m/min, die Temperatur war Raumtemperatur und die relative Luftfeuchte lag bei 30 %. Damit wurden folgende Werte gemessen: Der Reibungskoeffizient lag bei $\mu = 0,8$ und war somit relativ sehr hoch, und ein vorgegebener Laufweg der Hartmetallkugel auf der Schicht von 50 m konnte nicht erreicht werden, da schon vorher eine Ablösung der Schicht an der Berührungsstelle erfolgte. Zum Verständnis des "Laufweges" wird auf folgendes verwiesen: Die Hartmetallkugel glitt auf dem scheibenförmigen Probesubstrat um dessen Mitte auf einer Kreisbahn mit einem Radius von 8 mm, so daß der sich daraus ergebende Kreisumfang viele Male durchlaufen wurde. Das bei weitem nicht erreichte Ziel lag bei insgesamt ca. 1.100 Gesamtumdrehungen.

Weitere Versuche mit einem Kratz-Testgerät des Typs A 150 Scratch-Test der gleichen Firma CSEM führten zu deutlich sichtbaren Kratzspuren auf der Beschichtung. Auf beiden Seiten der Kratzspuren waren auf großer Weglänge Oberflächenteile der Schicht regelrecht abgeplatz. Ein Eindringtest nach "Rockwell" mit einem Handhärteprüfer der Firma Fritschi GmbH in D-8500 Nürnberg-40, führte nicht nur zu einem deutlich sichtbaren Eindruck der Prüfkugel, sondern auch zur Ausbildung von radialen Rissen in der Beschichtung innerhalb einer kreisringförmigen Zone, deren mittlerer Durchmesser etwa den 2- bis 3-fachen Durchmesser des Abdrucks der Prüfkugel hatte.

### Beispiel 2 (Vergleichsbeispiel):

Um eine Verbesserung dieser Eigenschaften zu erzielen, wurden die Substrate zwischen dem Ätzprozeß und der Beschichtung mit $CrN_x$ mit einer Zwischenschicht aus reinem Chrom mit einer Dicke von 0,5 μm versehen. Zu diesem Zweck wurde mit der Einleitung von Stickstoff erst begonnen, nachdem die genannte Zwischenschicht die angegebene Dicke erreicht hatte. Die übrigen Verfahrensparameter beim Ätzen und Beschichten mit der $CrN_x$-Schicht blieben unverändert. Die Schichtfolge Substrat-Chrom-$CrN_x$ zeigte jedoch im Tribometer-Test die gleichen schlechten Eigenschaften: Es erfolgten Schichtablösungen schon nach wenigen Metern Laufweg und deutlich sichtbare Schleifspuren. Auch bei dem Rockwell-Test zeigten sich die bereits beschriebenen radial verlaufenden Risse innerhalb einer Kreisringzone um den Kugeleindruck.

### Beispiel 3 (Vergleichsbeispiel):

Es wurde noch versucht, unter ansonsten gleichen Beschichtungsbedingungen die Ätzzeiten zu verlängern, und zwar auf mehr als die doppelten Werte. Auch dadurch konnte die Haftfestigkeit der Beschichtung nicht verbessert werden. Außerdem entstand ein zusätzlicher Nachteil durch einen Härteverlust des Grundmaterials (Werkstoff 100Cr6) bereits nach dem Ätzvorgang.

### Wertung der Vergleichsbeispiele 1 bis 3:

Bei Anwendung einer Vorrichtung nach Figur 1 kann selbst durch sehr lange Ätzzeiten und/oder durch den Einsatz erhöhter Temperaturen bei der Ätzung keine ausreichend zuverlässige Entfernung von Oberflächenverunreinigungen durch das Ionenätzen garantiert werden.

Mittels dieser Vorrichtung konnte während des Beschichtungsvorganges am Substrat nur eine maximale Stromdichte erreicht werden, die unterhalb von 0,5 $mA/cm^2$ der Substratoberfläche lag. Derart geringe Stromdichten an den Substraten führten ganz offensichtlich dazu, daß Schichten mit nicht-optimalem Wachstum und geringer Dichte niedergeschlagen wurden. Dies bedeutet insbesondere, daß auch eine Erhöhung der Bewegungsgeschwindigkeit der kondensierenden Partikel nicht in ausreichendem Maße möglich war, so daß auch keine hohe Dichte des kondensierten Beschichtungsmaterials auf den Substraten erreicht wurde. Dies äußerte sich insbesondere dadurch, daß die betreffenden Schichten eine säulenförmige Mikrostruktur mit klaffender, unregelmäßiger Oberfläche aufwiesen.

Durch diese rasche säulenförmige Mikrostruktur werden für die Beanspruchung der Schichten auf technischen Bauteilen, auf Werkzeugen und nicht zuletzt auf Schmuckgegenständen ungünstige Verhältnisse bezüglich der Reibungseigenschaften und des Verschleißes erzeugt.

### Beispiel 4:

Die Vorrichtung nach Figur 1 wurde nunmehr durch den Einbau der Wände 20, 25 und 26 mit den Magnetanordnungen 23, 27 und 28 sowie durch den Einbau der Anode 30 in der Weise umgerüstet, daß sie der Figur 2 entsprach.

Beim Ionenätzen wurde ein Argondruck von 1,8 x $10^{-2}$ mbar, ein Substratpotential von -1750 V und ein Anodenpotential von +40 V eingestellt. Hierbei ergaben sich Stromdichten an den Substraten von deutlich über 1 $mA/cm^2$ Substratoberfläche. Es konnte eine deutlich sichtbare Ätzwirkung am Gefüge über alle Oberflächenbereiche der Substrate erreicht werden.

Auch beim Beschichten konnten sehr hohe Stromdichten an den Substraten erreicht werden. Die Stromwerte wurden bei gleichem Anodenpotential von +40 V für einen Katodenstrom von 7,2 A, einem Katodenpotential von -560 V und einem Substratpotential von -60 V ermittelt. Hierbei ergaben sich in Abhängigkeit von der Magnetfeldstärke am Target (siehe auch Figur 6) typische Stromdichtewerte an den Substraten zwischen 1,0 und 1,5 mA/cm$^2$ Substratoberfläche. Bei der Beschichtung wurde mit einem Argondruck von 6 x 10$^{-3}$ mbar gearbeitet sowie mit einem Stickstoff-Fluß von 27 sccm, der dem Argonfluß beigemischt wurde.

Figur 5 zeigt den Einfluß einer Veränderung der Anodenspannung auf die Stromdichte A$_S$ an den Substraten. Es war also möglich, durch Einstellung des Anodenpotentials den Substratstrom zu steuern.

Figur 5 zeigt, daß, beginnend mit 0 V Anodenspannung und einer geringen Stromdichte von 0,03 mA/cm$^2$ Substratoberfläche durch Steigerung der Anodenspannung auf 60 V eine Stromdichte von 1,1 mA/cm$^2$ und bei einer Anodenspannung von 100 V sogar eine Stromdichte von 1,35 mA/cm$^2$ eingestellt werden konnte. Beim Ätzen mit einer Stromdichte von 1,1 mA/cm$^2$ und beim Beschichten mit einer Stromdichte von 1,5 mA/cm$^2$ Substratoberfläche mit CrN$_x$ zeigte sich neben einer ausreichend guten Haftung der Schicht ein niedriger Reibungskoeffizient von $\mu = 0,3$ (im Vergleich zu $\mu = 0,8$ bei Beispiel 1). Bei dem Reibungstest mit dem vorstehend beschriebenen Tribometer ergab sich ein Laufweg von über 55 m, ohne daß eine nennenswerte Reibungsspur sichtbar geworden wäre.

Die durch den Kratz-Test verursachte Kratzspur verlief über eine lange Wegstrecke glatt ohne nennenswerte Ausbrüche der Beschichtung an den Seitenkanten der Kratzspur. Beim Rockwell-Test mit dem weiter oben beschriebenen Handhärte-Prüfgerät konnte eine Aufwölbung am Rand des Kugelabdrucks beobachtet werden, desgleichen natürlich eine entsprechende Verformung der Beschichtung, nicht aber die bei den Vergleichsversuchen beobachtete Ausbildung radialer Risse in der Beschichtung im Abstand vom Kugeleindruck.

Die Untersuchung der Beschichtung unter dem Elektronenmikroskop ergab, daß eine glatte Oberfläche ohne mikroskopische Aufrauhung durch eine zerklüftete Säulenstruktur in der Beschichtung erzeugt wurde, worauf der geringe Reibungskoeffizient von $\mu = 0,3$ zurückzuführen sein dürfte.

Figur 6 zeigt nunmehr in überzeugender Weise den Einfluß des Erfindungsgegenstandes auf die Stromdichte A$_S$ an den Substraten, und zwar in Abhängigkeit von der negativen Bias-Spannung am Substrathalter: Die Kurven 41 und 42 zeigen die Zunahme der Stromdichte an den Substraten für zwei unterschiedliche maximale Horizontalkomponenten der Magnetfeldstärke an der Targetoberfläche (23 KA/m bzw. 24 KA/m). Bei diesen Werten hat eine Absenkung der Feldstärke an der Targetoberfläche keinen positiven Einfluß auf die Stromdichte an den Substraten. Auch eine Steigerung der negativen Bias-Spannung über etwa 40 V hinaus führt nicht dazu, daß die Stromdichte an den Substraten nennenswert über 0,5 mA/cm$^2$ Substratoberfläche gesteigert werden könnte.

Die Kurven 43, 44 und 45 gelten für den Erfindungsgegenstand bei gleicher Magnetfeldstärke an der Targetoberfläche (23 KA/m). Bereits bei einer Bias-Spannung an den Substraten V$_S$ von 0 Volt liegen die Substrat-Stromdichten deutlich höher, nämlich zwischen etwa 0,8 und 1,3 mA/cm$^2$ Substratoberfläche. Eine Steigerung der negativen Substratvorspannung (Bias-Spannung) führt zu einer kontinuierlichen Steigerung der Substrat-Stromdichte, vor allem aber führt eine Erhöhung der positiven Anodenspannung U$_A$ von 40 auf 100 V zu einer weiteren deutlichen Zunahme der Stromdichte an den Substraten.

**Beispiel 5 (Vergleichsbeispiel):**

In diesem Fall ging es darum, ein großvolumiges Formteil, nämlich einen Quader mit einem quadratischen Querschnitt mit einer Kantenlänge von 100 mm x 100 mm und einer Länge von 300 mm mit Titannitrid (TiN$_x$) zu beschichten.

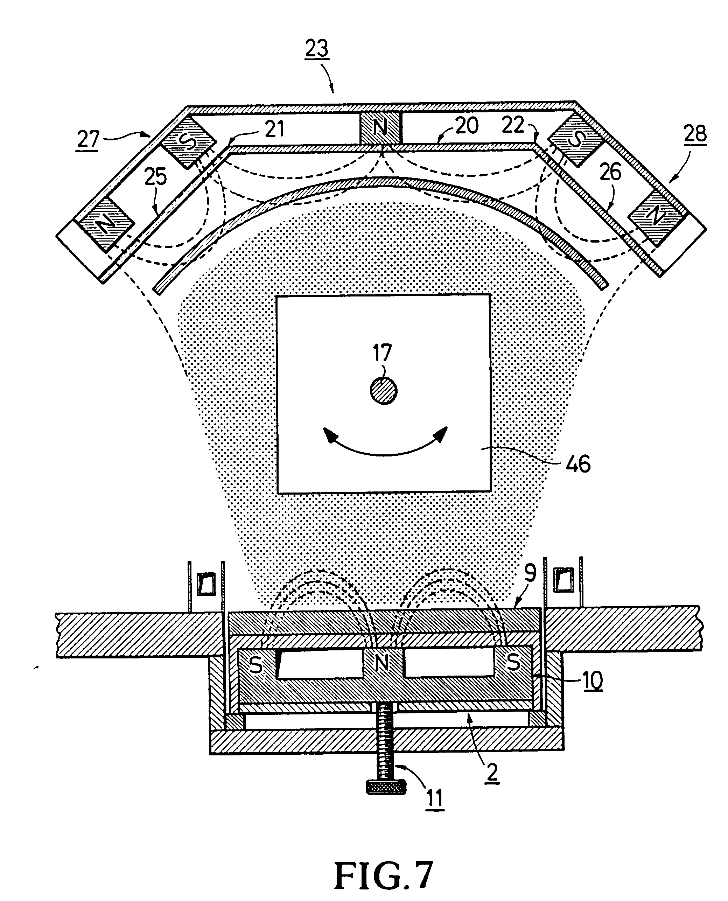

Die dazu benutzte Vorrichtung nach Figur 7 unterscheidet sich nur dadurch von derjenigen nach Figur 2, daß das Substrat (im Querschnitt gesehen) deutlich größere Abmessungen hat.

Die betreffende Vorrichtung wurde zunächst in einem Zustand betrieben, wie er analog in Figur 1 dargestellt ist, d.h. ohne die spezielle Anode und ohne die Wände 20, 25 und 26 mit den dahinter vorgesehenen Magnetanordnungen.

Um in diesem Fall überhaupt eine untersuchungsfähige Beschichtung durchführen zu können, muß eine Substratvorspannung von -150 bis -250 Volt gewählt werden, um bei den sich dann einstellenden Stromdichten von maximal 0,5 mA/cm$^2$ Substratoberfläche goldfarbene TiN$_x$-Schichten zu erzeugen. Diese Schichten haben bekanntlich einen goldähnlichen Charakter, wobei aber die nachstehend noch näher erläuterten Kennzahlen für Farbe und Glanz kritisch sind.

Für die Katode bedeutet dies, daß dort Leistungsdichten zwischen etwa 8 und 10 W/cm$^2$ Targetoberfläche eingestellt werden müssen, und daß dabei zur Erzeugung eines stöchiometrischen Titannitrids Stickstoff-Flüsse zwischen 35 und 40 sccm benötigt werden.

Für den vorausgehenden Prozeß der Ätzreinigung gelten ähnliche Überlegungen wie bei der Herstellung von Schichten aus CrN$_x$.

Es ist dennoch außerordentlich schwierig, haftfeste Beschichtungen auf großen Formteilen ohne zusätzliche Verstärkung des Ätzprozesses zu erzeugen. Während es noch möglich war, für dekorative Zwecke, dünne 0,25 bis 0,5 µm starke Titannitridschichten abzuscheiden, war es unmöglich, mit der bekannten Vorrichtung und Prozeßführung nach Figur 1 dickere Schichten für technische Zwecke (sogenannte funktionelle Schichten) mit einer Schichtdicke von 2 µm herzustellen. Mit zunehmender Schichtdicke werden nämlich zunehmend größere Eigenspannungen in der Beschichtung erzeugt, die schließlich zum Ablösen dickerer Schichten führen.

Hinzu kommt, daß dekorative Schichten auch nicht solchen mechanischen Belastungen ausgesetzt werden, wie funktionelle Schichten.

Das weiter oben beschriebene Substrat wurde bei einer Substratvorspannung von -200 V, einer Stromdichte von 0,3 mA/cm$^2$ Substratoberfläche mit einer goldfarbenen TiN$_x$-Schicht überzogen. Die betreffende Schicht zeigte geringe Brillanzwerte und eine starke Griffempfindlichkeit. Die starke Griffempfindlichkeit kann so beschrieben werden, daß die ungenügend dichte Beschichtung beim Anfassen der Schicht Hautschweiß und Feuchtigkeit aufsaugt und damit einen Fingerabdruck oder eine Griffspur sichtbar werden läßt. Selbst bei einem Abreiben einer solchen Stelle mit einem trockenen Tuch kann infolge der vorhandenen Kapillarwirkung der Schicht der Hand- oder Fingerabdruck nicht mehr entfernt werden. Des weiteren werden die für einen goldfarbenen Farbeindruck notwendigen charakteristischen Farbwerte nicht erreicht.

Maßgebend für die Charakterisierung der optischen Eigenschaften von dekorativen Oberflächen sind die sogenannten CIELAB-Einheiten, für die Meßverfahren und Vorrichtungen in der Literatur beschrieben sind. Im vorliegenden Fall wurde für die Messungen ein Farbmeßgerät der Firma Macbeth des Typs "Color-EYE 1500S" verwendet. Die Auswertung der Messung erfolgte in sogenannten L*-, a*- und b*-Einheiten. Hierbei kennzeichnet die Einheit L* die Brillanz der Schicht, während ein positiver a*-Wert den Rotwert und ein negativer a*-Wert den Grünwert im Farbton darstellt. Für den Wert b* bedeutet ein positiver Wert einen Gelbfarbton, während ein negativer b*-Wert einen Blaufarbton darstellt. Typische Werte für einen Goldfarbton sind L* = 89; a* = 1,2 und b* = 28, wenn bei der genannten Meßeinrichtung die Lichtquelle C (Katalogbezeichnung) eingesetzt wird.

Bei dem beschriebenen Verfahren nach dem Stande der Technik wurden folgende Werte erreicht:
$$L^* = 67$$
$$a^* = 3$$
$$b^* = 28.$$

Diese Werte bedeuten, daß ein stark rötlicher Farbton erreicht wird, der jedoch dadurch sehr unnatürlich erscheint, daß die Brillanz (L*) der Schicht sehr niedrig ist. Mit anderen Worten: Hier wird ein rötlicher, matter "Goldfarbton" erzeugt, der keinem Goldstandard entspricht. Derartige Schichten können nicht als dekorative Schichten eingesetzt werden.

**Beispiel 6:**

Mit der Vorrichtung und Anordnung nach Figur 7 wurde beim Beschichtungsprozeß mit TiN$_x$ die Magnetronkatode bei einem Katodenpotential von -500 V und einem Katodenstrom von 10 A betrieben. Am Substrat lag während der Beschichtung eine Vorspannung von -120 V an, wobei an der Anode gleichzeitig ein Potential von +40 V eingestellt wurde. Bei diesen Betriebsparametern wurde am Substrat ein Substratstrom von 2,6 A gemessen, woraus sich bei den vorstehend beschriebenen Substratdimensionen eine Substratstromdichte von 2,2 mA/cm$^2$ Substratoberfläche errechnet.

Bezogen auf das sehr große Formteil wurde eine dynamische Kondensationsrate von 0,6 nm/sec bestimmt, wodurch auf das Substrat nach einer Beschichtungszeit von 10 Minuten eine Schichtdicke von 0,35 µm abgeschieden wurde. Der Prozeßdruck, der durch Argoneinlaß eingestellt wurde, betrug 5 x 10$^{-3}$ mbar, während sich nach dem Einstellen des Stickstoff-Flusses von 35 sccm ein Partialdruck des Stickstoffs in der Gasatmosphäre von 5 x 10$^{-4}$ mbar bestimmen ließ. Als optische Werte wurden mit dem bereits beschriebenen Farbmeßgerät der Firma Macbeth folgende CIELAB-Werte gemessen:

| | |
|---|---|
| Brillanzwert : | L* = 77 |
| Rotwert : | a* = 0 |
| Gelbwert : | b* = 28. |

Eine Schicht mit diesen charakteristischen Werten ist als dekorative Goldschicht durchaus zulässig, da hierbei eine Farbgebung nach dem Schweizer Goldstandard 2N18 erzielt wurde.

Hinsichtlich der Griffempfindlichkeit wurde festgestellt, daß nach dem Anfassen der Schicht nur ein leichter Belag von Hautschweiß und Feuchtigkeit auf der Oberfläche erfolgte, der einfach mit einem trockenen Tuch abgewischt werden konnte. Diese charakteristischen Werte waren auf der gesamten Oberfläche des Substrats außerordentlich gleichmäßig.

**Wertung der Beispiele 4 bis 6:**

Die mittels der erfindungsgemäßen Vorrichtung hergestellten Chrom- und CrN$_x$-Schichten weisen den Vorteil auf, daß man bereits bei Anwendung sehr geringer Substratpotentiale von einigen 10 Volt und bei hohen Stromdichten zu dichten Schichten gelangt, die unter tribologischen Betriebsbedingungen auf technischen Bauteilen eingesetzt werden können. Dies ist insbesondere deshalb wichtig, weil neben der meist komplizierten Geometrie solcher Bauteile auch mit einer geringen Belastbarkeit durch hohe Temperaturen gerechnet werden muß. Auch hier stehen sich wiederum die Forderungen diametral entgegen, daß zum Zwecke einer großen Haftfestigkeit der erzeugten Schichten mit einem Verfahren gearbeitet werden sollte, das auf einem Ionen-Platierungs-Effekt beruht, daß aber andererseits die durch ein solches Verfahren bedingte hohe Temperaturbelastung des Substrats vermieden werden muß.

In diesem Zusammenhang spielt bereits die Möglichkeit einer Reduzierung des Substratpotentials von den in herkömmlichen Vorrichtungen meist angewandten -200 V auf die in der erfindungsgemäßen Vorrichtung möglichen -50 V Substratpotential bei hoher Stromdichte eine entscheidende Rolle, da diese Maßnahme die thermische Belastung der Substrate drastisch vermindert, dennoch aber die Gesamtanordnung ideale Voraussetzungen für das Schichtwachstum ermöglicht.

Die mit der erfindungsgemäßen Vorrichtung erzeugten Schichten sind somit für komplizierte Form- und Bauteile im gesamten Maschinenbau geeignet, beginnend mit Kugellagerstählen, Kaltarbeitsstählen, niedrig legierten Stählen bis hin zum Werkzeugstahl und zum Hartmetall.

Bei den mittels der erfindungsgemäßen Vorrichtung hergestellten Schichten aus $TiN_x$, die sowohl für dekorative als auch für technische Zwecke geeignet sind, zeigte sich folgendes: Die betreffenden Schichten sind bezüglich der Griffempfindlichkeit bzw. Beständigkeit gegenüber Hautschweiß und Feuchtigkeit, als sehr gut einzustufen. Derartige Schichten können beispielsweise auch auf Gebrauchsgegenständen, wie Feuerzeughülsen, Schreibgeräten, Uhrengehäusen und Armbändern eingesetzt werden, ohne daß zum Schutze vor der Berührung der Beschichtung ein zusätzliches Lackieren oder ähnliche Vorgänge notwendig werden. Zusätzlich zeigt sich eine wesentlich höhere Farbgleichmäßigkeit über die gesamte Außenfläche des beschichteten Formteils, wobei dieses deutlich größere Abmessungen aufweisen kann, als die mit den herkömmlichen Vorrichtungen zu beschichtenden Formteile.

Anwendungen sind sowohl auf technischen Bauteilen als auch auf dekorativen Gegenständen möglich, aber auch funktionelle Anwendungen auf dem Gebiet der Beschichtung von Werkzeugen aus Kaltarbeitsstählen, Hochleistungs-Schnellstählen und Hartmetall kommen infrage.

Erste zusätzliche Versuche haben auch gezeigt, daß die anhand der Beschichtung von Substraten mit $TiN_x$ gewonnenen Erfahrungen auch auf die Beschichtung mit Schichten aus $TiAl-N_x$ sinngemäß übertragen werden können. Auch hier führt die erfindungsgemäße Vorrichtung zu bedeutenden Vorteilen hinsichtlich der Verfahrensführung und der Produkteigenschaften.

## Patentansprüche

1.  Vorrichtung zum Beschichten von Substraten durch Katodenzerstäubung mit

    a) einer rechteckigen Magnetronkatode (2), die ein Target (9) mit Längskanten (12,13) aufweist und einen Beschichtungsbereich definiert,
    b) einem um eine zu den Längskanten parallele Drehachse (17) drehbaren Substrathalter (16) für Substrate, deren Oberflächenelemente auf Kreisbahnen durch den Beschichtungsbereich bewegbar sind,
    c) einer flächenhaften, aus amagnetischem Werkstoff bestehenden Wand (20) mit Längskanten (21,22), die gleichfalls parallel zur Drehachse (17) des Substrathalters (16) verlaufen, wobei hinter der Wand eine Magnetanordnung (23) zur Erzeugung mindestens eines langgestreckten magnetischen Tunnels angeordnet ist, der sich über die dem Substrathalter zugekehrte Oberfläche der Wand erstreckt, wobei sich die Magnetronkatode (2) und die Wand (20) auf gegenüberliegenden Seiten der Drehachse (17) befinden und die Langseiten des magnetischen Tunnels gleichfalls parallel zu den Längskanten (12,13) des Targets (9) verlaufen, sowie mit
    d) einer flächenhaften Anode (30),

    **dadurch gekennzeichnet**, daß

    e) der Abstand zwischen den Längskanten (12, 13) des Targets (9) und den hierzu parallelen Längskanten (21, 22) der Wand (20) auf dem Umfang der Substratbahnen durch mindestens eine weitere Wand (25, 26) mit einer dahinter angeordneten Magnetanordnung (27, 28) verkürzt ist, wobei die mindestens eine weitere Magnetanordnung (27, 28) unter einem Winkel zur ersten Magnetanordnung (23) ausgerichtet ist, und daß
    f) die Pole aller Magnetanordnungen (23, 27, 28) sich auf dem Umfang des Substrathalters (16) abwechseln, derart, daß der gesamte Umfang des Substrathalters (16) von einer ununterbrochenen Folge von magnetischen Tunnels umgeben ist.

2.  Vorrichtung nach Anspruch 1, **dadurch gekennzeichnet**, daß die Wände (20, 25, 26) der Magnetanordnungen (23, 27, 28) in einer polygonalen Hüllfläche liegen, die mindestens den außerhalb der Sichtverbindung mit der Magnetronkatode (2) liegenden Teilumfang der Substratbahnen umschließt.

3.  Vorrichtung nach Anspruch 1, **dadurch gekennzeichnet**, daß die den Längskanten (12, 13) des Targets (9) benachbarten Pole des Magnetsystems (10) der Magnetronkatode (2) eine jeweils entgegengesetzte Polung zu denjenigen Polen der Magnetsysteme (27, 28) aufweisen, die von der Magnetronkatode den geringsten Abstand aufwei-

**4.** Vorrichtung nach Anspruch 3, **dadurch gekennzeichnet,** daß die von den außenliegenden Polen der Magnetronkatode (2) zu den nächstliegenden Polen der Magnetanordnungen (27, 28) verlaufenden Magnetfeldlinien maximaler Feldstärke die Substratbahnen nicht schneiden.

**5.** Vorrichtung nach Anspruch 4, **dadurch gekennzeichnet,** daß der minimale Abstand zwischen den Magnetfeldlinien maximaler Feldstärke und den Substratbahnen so dimensioniert ist, daß das Plasma den gesamten Umlaufweg der Substrate umschließt.

**6.** Vorrichtung nach Anspruch 1, **dadurch gekennzeichnet,** daß die flächenhafte Anode (30) als gebogene Elektrode zwischen dem nicht in Sichtverbindung mit der Magnetronkatode (2) stehenden Teilumfang der Substratbahnen und den Magnetsystemen (23, 27, 28) angeordnet ist.

**Claims**

**1.** Device for coating substrates by cathode sputtering, having

a) a rectangular magnetron cathode (2), which has a target (9) with longitudinal edges (12, 13) and defines a coating region,
b) a substrate holder (16) rotatable about an axis of rotation (17) parallel to the longitudinal edges for holding substrates, the surface elements of which are movable along circular paths through the coating region,
c) an areal wall (20) made of non-magnetic material and having longitudinal edges (21, 22) likewise extending parallel to the axis of rotation (17) of the substrate holder (16), a magnet arrangement (23) being disposed behind the wall for generating at least one elongated magnetic tunnel which extends over the surface of the wall facing the substrate holder, the magnetron cathode (2) and the wall (20) being situated on opposite sides of the axis of rotation (17) and the long sides of the magnetic tunnel likewise extending parallel to the longitudinal edges (12, 13) of the target (9), as well as having
d) an areal anode (30),

**characterized in that**

e) the distance between the longitudinal edges (12, 13) of the target (9) and the longitudinal edges (21, 22) parallel thereto of the wall (20) on the periphery of the substrate paths is shortened by at least one further wall (25, 26), behind which a magnet arrangement (27, 28) is disposed, the at least one further magnet arrangement (27, 28) being aligned at an angle to the first magnet arrangement (23),
and that
f) the poles of all of the magnet arrangements (23, 27, 28) alternate on the periphery of the substrate holder (16) in such a way that the entire periphery of the substrate holder (16) is surrounded by an uninterrupted sequence of magnetic tunnels.

**2.** Device according to claim 1, **characterized in that** the walls (20, 25, 26) of the magnet arrangements (23, 27, 28) lie in a polygonal enveloping surface which encloses at least the partial periphery of the substrate paths which lies outside of the visual contact with the magnetron cathode (2).

**3.** Device according to claim 1, **characterized in that** the poles of the magnet system (10) of the magnetron cathode (2) which are adjacent to the longitudinal edges (12, 13) of the target (9) are in each case opposite to the poles of the magnet systems (27, 28) which are at the smallest distance from the magnetron cathode.

**4.** Device according to claim 3, **characterized in that** the magnetic lines of force of maximum field strength which extend from the outer-lying poles of the magnetron cathode (2) to the immediately adjacent poles of the magnet arrangements (27, 28) do not cut the substrate paths.

**5.** Device according to claim 4, **characterized in that** the minimum distance between the magnetic lines of force of maximum field strength and the substrate paths is so dimensioned that the plasma encloses the entire circular path of the substrates.

**6.** Device according to claim 1, **characterized in that** the areal anode (30) is disposed as a curved electrode between the partial periphery of the substrate paths, which is not in visual contact with the magnetron cathode (2), and the magnet systems (23, 27, 28).

**Revendications**

**1.** Dispositif pour le revêtement de substrats par pulvérisation cathodique comprenant

a) une cathode de magnétron rectangulaire (2) qui présente une cible (9) comportant des arêtes longitudinales (12, 13) et qui définit un domaine de revêtement,

b) un support de substrat (16) capable de tourner autour d'un axe de rotation (17) parallèle aux arêtes longitudinales pour des substrats dont les éléments de surface peuvent se déplacer sur des trajectoires circulaires dans le domaine de revêtement,

c) une paroi étendue (20), consistant en un matériau amagnétique, comportant des arêtes longitudinales (21, 22) qui s'étendent de même parallèlement à l'axe de rotation (17) du support de substrat (16), un agencement d'aimants (23) étant disposé derrière la paroi pour la production d'au moins un tunnel magnétique allongé qui s'étend au-dessus de la surface de la paroi tournée vers le support de substrat, la cathode de magnétron (2) et la paroi (20) se trouvant sur des côtés opposés de l'axe de rotation (17) et les côtés longitudinaux du tunnel magnétique s'étendant de même parallèlement aux arêtes longitudinales (12, 13) de la cible (9), et

d) une anode étendue (30),

caractérisé en ce que

e) la distance entre les arêtes longitudinales (12, 13) de la cible (9) et les arêtes longitudinales (21, 22) parallèles aux précédentes de la paroi (20) est raccourcie sur la périphérie des trajectoires des substrats par au moins une autre paroi (25, 26) avec un agencement d'aimants (27, 28) disposé derrière, un agencement d'aimants supplémentaire (27, 28) au moins étant orienté sous un angle par rapport au premier agencement d'aimants (23),

et en ce que

f) les pôles de tous les agencements d'aimants (23, 27, 28) alternent sur la périphérie du support de substrat (16) de telle manière que la périphérie totale du support de substrat (16) est entourée par une suite ininterrompue de tunnels magnétiques.

2. Dispositif selon la revendication 1, caractérisé en ce que les parois (20, 25, 26) des agencements d'aimants (23, 27, 28) sont situées dans une surface enveloppante polygonale qui entoure au moins la périphérie partielle des trajectoires de substrat située à l'extérieur du contact visuel avec la cathode de magnétron (2).

3. Dispositif selon la revendication 1, caractérisé en ce que les pôles du système d'aimants (10) de la cathode de magnétron (2) qui sont voisins des arêtes longitudinales (12, 13) de la cible (9) présentent chacun une polarité opposée aux pôles des systèmes d'aimants (27, 28) qui présentent la plus faible distance avec la cathode de magnétron.

4. Dispositif selon la revendication 3, caractérisé en ce que les lignes de champ magnétique d'intensité de champ maximale qui s'étendent des pôles extérieurs de la cathode de magnétron (2) aux pôles les plus proches des agencements d'aimants (27, 28) ne coupent pas les trajectoires des substrats.

5. Dispositif selon la revendication 4, caractérisé en ce que la distance minimale entre les lignes de champ magnétique d'intensité de champ maximale et les trajectoires des substrats est dimensionnée de telle manière que le plasma entoure la totalité de la course de rotation des substrats.

6. Dispositif selon la revendication 1, caractérisé en ce que l'anode étendue (30) est agencée sous forme d'électrode incurvée entre la périphérie partielle des trajectoires des substrats qui n'est pas située en contact visuel avec la cathode de magnétron (2) et les systèmes d'aimants (23, 27, 28).

FIG.1

HV$_{0,01}$ [Kp/mm$^2$]

FIG.4

f N2 [sccm]

FIG. 2

FIG.3

A_S [mA/cm²]

FIG.5

A_S [mA/cm²]

FIG.6

FIG.7